# EUROPEAN PATENT SPECIFICATION

(11) **EP 2 696 352 B1**
(45) Date of publication and mention of the grant of the patent: **09.12.2015**
(21) Application number: 12768065.0
(22) Date of filing: 06.04.2012
(51) Int. Cl.: H01B 1/20, H01B 1/02, H01B 1/04, H01L 31/042, H01B 1/22

(54) **SILVER PASTE COMPOSITION FOR FORMING AN ELECTRODE, AND METHOD FOR PREPARING SAME**
SILBERPASTENZUSAMMENSETZUNG ZUR FORMUNG EINER ELEKTRODE UND VERFAHREN ZU IHRER HERSTELLUNG
COMPOSITION DE PÂTE D'ARGENT POUR FORMER UNE ÉLECTRODE, ET PROCÉDÉ POUR SA PRÉPARATION

(30) Priority: 07.04.2011 KR 20110032244
(43) Date of publication of application: 12.02.2014
(73) Proprietor: LG CHEM, LTD., Seoul 150-721 (KR)
(72) Inventor: LEE, Su-Hee, Daejeon 305-761 (KR); HEO, Soo-Yeon, Daejeon 305-761 (KR)
(74) Representative: Goddar, Heinz J.
(86) International application number: PCT/KR2012/002645
(87) International publication number: WO 2012/138186

(56) References cited:
- WO-A2-2009/148259
- KR-A- 20090 029 305
- KR-A- 20090 030 995
- KR-A- 20090 126 427
- KR-A- 20100 127 619

## Description

### [Technical Field]

The present invention relates to a silver paste composition for forming an electrode and a preparation method thereof. More particularly, the present invention relates to a silver paste composition for forming an electrode, which allows formation of an electrode for a solar cell showing more improved printability, excellent electrical properties, and energy conversion efficiency and a preparation method thereof, a front electrode for a solar cell and a silicon solar cell that are formed from the silver paste composition.

### [Background Art]

Recently, with development of electronic industry, there is demand for miniaturization and high reliability of electronic products and devices. To meet the demand, various attempts have been made to form circuit patterns or electrodes of electronic products requiring high integration. Under such circumstances, use of a conductive metal paste is the center of interest because it hardly generates by-products or contaminants during a process.

A typical metal paste includes a conductive metal, a glass frit and an organic binder, and the conductive metal includes silver, aluminum or the like. Currently, the conductive metal paste is mainly used to mount a hybrid IC or a semiconductor IC, or to form various condensers or electrodes, and recently has the expanded application range to high-tech electronic products such as PCBs, ELs, touch panels, RFIDs, LCDs, PDPs or solar cells. With expansion and development of the related industry, demand for the conductive metal paste is increasing.

In particular, as it is expected that conventional energy sources such as oil or charcoal will be exhausted, interests in alternative energy are increasing. Among alternative energy, a solar cell has abundant energy sources and does not cause an environmental pollution, and thus it becomes the object of attention.

The solar cell is classified into a solar heat cell that produces vapor required to run a turbine using a solar heat, and a solar light cell that converts photons into an electrical energy using properties of a semiconductor. Generally, the solar light cell (hereinafter, referred to as a solar cell) is represented as a solar cell.

The solar cell is largely divided into a silicon solar cell, a compound semiconductor solar cell, and a tandem solar cell according to the raw material. Among these three types of solar cells, the silicon solar cell leads the solar cell market.

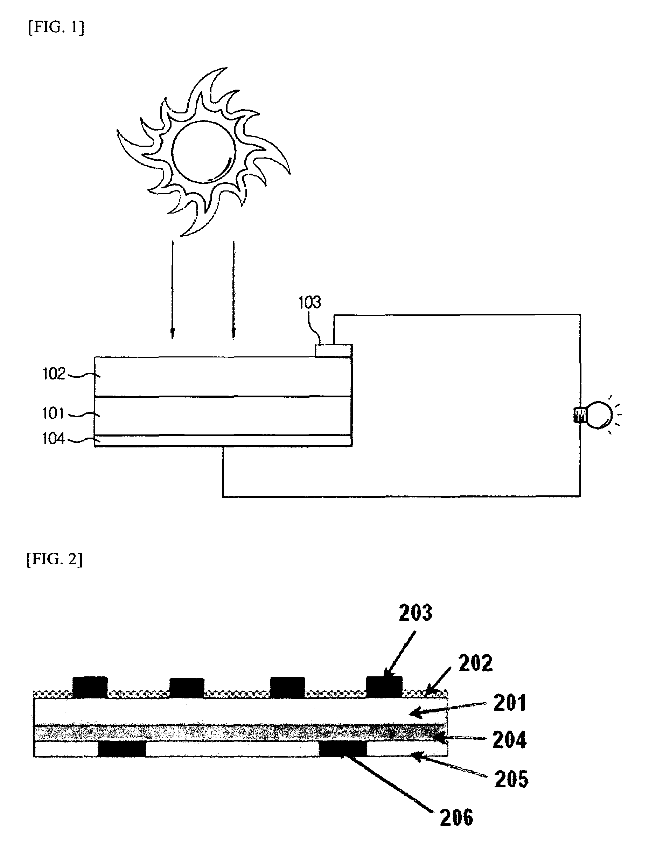

FIG. 1 is a cross-sectional view showing a basic structure of a silicon solar cell. Referring to FIG. 1, the silicon solar cell includes a substrate 101 composed of a p-type silicon semiconductor, and an emitter layer 102 composed of an n-type silicon semiconductor. A p-n junction is formed at an interface between the substrate 101 and the emitter layer 102 in the similar way to a diode. In addition, FIG. 2 is a schematic view showing constitution of a front electrode in the structure of the solar cell. As shown in FIG. 2, a silver electrode is mainly formed as a front electrode on the front surface of a substrate of a solar cell, and an aluminium electrode and a silver electrode are formed as a back electrode on the back surface of a substrate. In this regard, the front electrode is, not shown in the drawing, connected to the emitter layer through an antireflection film upon formation of the silicon solar cell.

When solar light is incident on the solar cell of the above-mentioned structure, electrons and holes create in the silicon semiconductors doped with impurities by the photovoltaic effect. For reference, electrons are created in the emitter layer 102 composed of an n-type silicon semiconductor as a plurality of carriers and holes are created in the substrate 101 composed of a p-type silicon semiconductor as a plurality of carriers. The electrons and holes created by the photovoltaic effect are drawn toward the n-type silicon semiconductor and p-type silicon semiconductor, and move to a front electrode 103 on the emitter layer 102 and a back electrode 104 below the substrate 101, respectively. Then, these electrodes 103, 104 are connected by a wire, so that the current flows.

A conductive metal paste is used to form a front or back electrode in a solar cell, in addition to various electrodes of other electronic products as mentioned above. The front electrode of a commercial crystalline silicon solar cell is formed by a screen printing process. In order to more improve the energy conversion efficiency through the above described procedures, contact properties between the front silver electrode and the silicon emitter layer should be more improved. In order to increase conductivity of the front electrode, the front electrode having a thinner line width and a taller line height should be formed. In addition, to improve fill factors of the solar cell, silver included in the first electrode should be stably recrystallized on the emitter layer of the solar cell.

However, when the front electrode is formed using the known silver paste, it is difficult to fully improve contact properties between the front silver electrode and the silicon emitter layer, and there is a limit in formation of the front electrode having a thinner line width and a taller line height. Therefore, there is a limit in improvement of energy conversion efficiency of the solar cell. In particular, recent studies have focused on energy conversion efficiency even for a 0.1 % increase.

### [Disclosure]

### [Technical Problem]

The present invention provides a silver paste composition for forming an electrode, which allows formation of an electrode for a solar cell showing more improved printability and excellent electrical properties and energy conversion properties, and a preparation method thereof.

Further, the present invention provides a front electrode for a solar cell and a silicon solar cell, which are formed from the silver paste composition.

### [Technical Solution]

The present invention provides a silver paste composition for forming an electrode, comprising a silver powder, a glass frit powder, an organic binder, and carbon black, in which the carbon black has a surface oxygen/carbon atomic ratio (O/C ratio) of approximately 0.4 or higher, for example, approximately 0.4 to 0.45.

Further, the present invention provides a method for preparing the silver paste composition for forming an electrode, comprising the steps of preparing a silver paste mixture that includes a silver powder, a glass frit powder, an organic binder, and secondary particle-type carbon black having a surface oxygen/carbon atomic ratio (O/C ratio) of approximately 0.4 or higher and a diameter of 1 to 5 µm; and dispersing the silver paste mixture.

Further, the present invention provides a front electrode for a solar cell, which is formed from the above described silver paste composition.

Further, the present invention provides a silicon solar cell, comprising a silicon semiconductor substrate; an emitter layer formed on the substrate; an antireflection film formed on the emitter layer; a front electrode connected to the emitter layer through the antireflection film; and a back electrode connected to a back surface of the substrate, in which the front electrode is formed by applying the above described silver paste composition on the antireflection film in a predetermined pattern and sintering the silver paste composition.

### [Advantageous Effects]

The silver paste composition for forming an electrode of the present invention includes carbon black having specific physical properties to more improve contact properties between silver and silicon when it is printed to form the electrode for a solar cell. In addition, the silver paste composition shows excellent printability, and allows formation of the electrode for the solar cell having a thinner line width and a taller line height.

Therefore, the silver paste composition can be used to form the solar cell having more improved electrical properties and energy conversion properties, and to effectively form the electrode thereof.

### [Description of Drawings]

The following accompanying drawings are included to illustrate the preferred embodiments or examples of the present invention and to provide a further understanding of the scope of the present invention together with the following detailed description of the present invention. Therefore, the present invention is not intended to be limited by these drawings and the scope of the present invention will be defined only by the appended claims.
FIG. 1 is a cross-sectional view showing a schematic structure of a typical silicon solar cell;
FIG. 2 is a schematic view of a solar cell that is manufactured by using a silver paste composition for forming a front electrode according to one embodiment;
FIG. 3 is electron microscopic images of front electrodes for a solar cell manufactured using silver paste compositions of Example 1 and Comparative Example 1, taken at the optimal view angle for each stereoscopic image;
FIG. 4a is a graph of carbon black used in Comparative Example 1, analyzed by XPS;
FIG. 4b is a graph of carbon black used in Example 1, analyzed by XPS; and
FIG. 5 is a graph showing a comparison of energy conversion (light conversion) efficiency between solar cells of Example 1 and Comparative Example 1.

### [Reference Numeral]

101: substrate
102: emitter layer
103: front electrode
104: back electrode
201: substrate
202: antireflection film
203: front electrode
204: BSF layer
205: back electrode
206: (back) silver electrode pattern

### [Best Mode]

Hereinafter, a silver paste composition for forming an electrode according to embodiments of the present invention, a preparation method thereof, and an electrode and a solar cell formed therefrom will be described in more detail.

According to one embodiment of the present invention, provided is a silver paste composition for forming an electrode, comprising a silver powder, a glass frit powder, an organic binder, and carbon black, in which the carbon black has a surface oxygen/carbon atomic ratio (O/C ratio) of approximately 0.4 or higher.

The silver paste composition of one embodiment includes carbon black having the surface oxygen/carbon atomic ratio of approximately 0.4 or higher, for example, approximately 0.35 to 0.50, approximately 0.4 to 0.45, or approximately 0.41 to 0.44. The oxygen/carbon atomic ratio can be measured and examined by relative intensity of atomic oxygen and carbon peaks (oxygen atom: O₁ₛ peak; carbon atom: C₁ₛ peak) in XPS (x-ray photoelectron spectroscopy) spectrum of the surface of carbon black.

The carbon black having a relatively high oxygen/carbon atomic ratio is included to more improve contact properties between silver and silicone of a substrate, when the front electrode for the solar cell is formed by printing and sintering the silver paste composition. This is because the carbon black having the specific properties allows the glass frit powder to effectively melt on the surface of silver powder upon sintering, and thus silver particles are melted at a lower temperature and diffused into the emitter layer. As a result, more stable fire-through occurs upon the sintering, thereby more improving contact properties between silver and silicon and forming a stable ohmic-contact between the substrate and the front electrode. Consequently, fill factors of the solar cell are improved, and the solar cell having more improved electrical characteristics and energy conversion properties can be provided.

Further, the silver paste composition of one embodiment has improved rheological characteristics, because it includes the above described carbon black. Thus, printability can be more improved through screen printing, and the electrode having a thinner line width and a taller line height can be effectively formed. Accordingly, the silicon solar cell having more excellent properties and the front electrode thereof can be effectively formed using the silver paste composition of one embodiment.

If the carbon black has too low surface oxygen/carbon atomic ratio, it is difficult to improve the electrical characteristics and energy conversion efficiency of the solar cell, like the known solar cell and the front electrode thereof. In addition, if the carbon black has too high surface oxygen/carbon atomic ratio, rheological characteristics of the silver paste is deteriorated, which is not suitable for screen printing, and fire-through becomes unstable upon sintering for the formation of the electrode and it is difficult to improve the fill factors.

Hereinafter, the individual ingredients of the silver paste composition of one embodiment will be described in more detail.

In the silver paste composition, the carbon black may be in the form of secondary particles formed by attachment or aggregation of a plurality of primary particles. In addition, the carbon black may have a diameter of approximately 0.02 to 2 µm, or approximately 0.03 to 1 µm, or approximately 30 to 800nm. In this regard, the primary particle of the carbon black may be defmed as a carbon black particle in the form of a single particle, and the secondary particle may be defmed by attachment or aggregation of a plurality of single particles (namely, primary particle) of the carbon black. In the secondary particle-type carbon black, the diameter can be defined by the largest linear distance between any two points on the surface of each secondary particle. The diameter of the secondary particle-type carbon black may be determined by analyzing the carbon black using SEM images.

If the carbon black is included in the silver paste composition in the form of the primary particle or has a too small diameter, it is difficult to prepare the silver paste composition having a viscosity within a proper range, and printability and processibility of the silver paste composition may be reduced. If the carbon black has a too large diameter, the carbon black is not sufficiently dispersed in the silver paste composition, but included in the form of large aggregates. Thus, it is difficult to improve the electrical characteristics by the carbon black, and printability of the silver paste composition may be reduced.

In order to include the carbon black having the above described secondary particle form and diameter in the silver paste composition of one embodiment, the primary particles of carbon black are aggregated to form secondary particles of the carbon black (commercially available or directly synthesized), and the carbon black is mixed with other ingredients to form a silver paste mixture, and then individual ingredients are dispersed while fine pulverization of the secondary particles of the carbon black is adjusted during a dispersing process, which will be described in more detail, hereinbelow.

In order to prepare the carbon black having the proper surface oxygen/carbon atomic ratio, the carbon black is subjected to surface heat treatment, surface plasma treatment, or surface acid treatment so as to control the amount of oxygen-containing functional groups created on the surface of carbon black. A more detail description of the treatment process of the carbon black will be provided in the following description regarding the preparation method of the silver paste.

The carbon black may be included in an amount of approximately 1 to 10% by weight, or approximately 2 to 8% by weight, or approximately 3 to 7% by weight, based on the total weight of the silver paste composition. If the content of the carbon black is too low, the silver paste composition may have low thixotropic index (T. I) to reduce printability or processibility, and sufficient improvement of electrical characteristics by the carbon black may not be achieved. On the contrary, if the content of the carbon black is too high, printability or processibility may be reduced during screen printing, and mask clogging may occur.

Meanwhile, the silver paste composition of one embodiment includes a silver powder as a conductive powder. In the silver paste composition, particle form and diameter of the silver powder can be adjusted considering the conditions, under which stable fire-through occurs upon sintering for the electrode formation and the final sintering occurs uniformly. For example, the silver powder may include a non-spherical silver powder such as flakes, but preferably a spherical silver powder having a mean diameter of approximately 1 to 3 µm or approximately 2 to 3 µm.

If the mean diameter of the silver powder is too small, ohmic-contact may not sufficiently occur. If the mean diameter of the silver powder is too large, viscosity of the silver paste composition becomes low, and thus the line height of the electrode cannot be sufficiently increased.

Further, the silver powder may be included in an amount of approximately 70 to 90% by weight or approximately 75 to 85% by weight, based on the total weight of the silver paste composition. If the content of the silver powder is too high, flowability and printability of the silver paste composition may be deteriorated. If the content of the silver powder is too low, resistance of the electrode may increase to deteriorate the electrical characteristics.

Further, the silver paste composition of one embodiment includes a glass frit powder. The glass frit powder is melted onto the surface of the silver powder upon sintering, and functions to make contact between silver and silicone of the substrate.

Any glass frit powder generally used in the paste for forming an electrode may be used without limitation as the glass frit powder. The glass frit powder may include, for example, a lead-containing glass frit powder containing PbO or a Bi-based lead-free glass frit powder containing no Pb. However, in order to more improve the properties of the electrode, for example, the contact properties between silver and silicone, the lead-containing glass frit powder may be more preferably used.

Examples of the lead-containing glass frit powder may include PbO-ZnO-Al₂O₃-TiO₂, PbO-SiO₂-B₂O₃, PbO-SiO₂-B₂O₃-ZnO, or PbO-SiO₂-B₂O₃-Al₂O₃-ZnO, and examples of the lead-free glass frit powder may include Bi₂O₃-B₂O₃-SiO₂, Bi₂O₃-B₂O₃-ZnO or Bi₂O₃-TlOx-B₂O₃-SiO₂. In addition, a variety of glass frit powder may be used, and mixtures of two or more thereof or mixtures of the lead-containing glass frit powder and the lead-free glass frit powder may be used.

Meanwhile, the silver paste composition of one embodiment includes an organic binder. In the preparation of the paste by mixing the silver powder, the glass frit powder and the carbon black, the organic binder is used for the purpose of dispersing the ingredients uniformly. Any organic binder generally used for the preparation of conductive paste compositions may be used without limitations as the organic binder. For example, the organic binder may include mixtures of two or more selected from the group consisting of cellulose resins, acrylic resins, butyl carbitol, and terpineol, but is not limited thereto. For example, the organic binder may be used by dissolving ethyl cellulose or acrylic resin in one or more organic solvents selected from the group consisting of butyl carbitol and terpineol.

Further, the contents of the above described glass frit powder and organic binder may be adjusted within a proper range, so that the silver paste composition of one embodiment has viscosity and properties suitable for the screen printing and electrode formation, and flowability is optimized to form an electrode having a higher line height.

For example, the glass frit powder may be included in an amount of approximately 1 to 5% by weight or approximately 2 to 3% by weight, based on the total weight of the silver paste composition. If the organic binder is in the form of a resin dissolved in an organic solvent, the liquid organic binder may be included in an amount of approximately 5 to 15% by weight or approximately 8 to 12% by weight, based on the total weight of the silver paste composition. In this regard, the contents of the resin and the organic solvent that are used to obtain the liquid organic binder are not particularly limited, but they may be included so that the resin can be properly dissolved and the liquid organic binder is able to properly disperse other ingredients.

Optionally, the silver paste composition of one embodiment may further include an additive. If necessary, the silver paste composition may further include, for example, conductive metal particles, an anti-foaming agent, a dispersing agent, or a plasticizer, in addition to the silver powder. The type or content of each additive is well-known to those skilled in the art, and the silver paste composition may further include an organic solvent, if necessary.

The above described silver paste composition of one embodiment may show a viscosity of approximately 100,000 to 400,000 cP or approximately 200,000 to 300,000 cP (brookfield viscometer, spindle 14, measurement temperature 25C, rotation speed 10 rpm). As the silver paste composition has the above viscosity, it exhibits more excellent printability. In addition, the silver paste composition can be used to form an electrode having a thinner line width and a taller line height.

Meanwhile, according to another embodiment of the present invention, provided is a preparation method of the above described silver paste composition. This preparation method may include the steps of preparing a silver paste that includes the silver powder, the glass frit powder, the organic binder, and the secondary particle-type carbon black having the surface oxygen/carbon atomic ratio (O/C ratio) of approximately 0.4 or higher and a diameter of 1 to 5 µm; and dispersing the silver paste.

Further, this preparation method may further include the steps of forming carbon black having the surface oxygen/carbon atomic ratio (O/C ratio) of approximately 0.4 or higher by surface-treatment of the primary particle-type carbon black having a diameter of approximately 20 to 50 nm; and aggregating the surface-treated carbon black to prepare the secondary particle-type carbon black having a diameter of approximately 1 to 5 µm, before preparation of the paste.

After preparing the carbon black having the surface oxygen/carbon atomic ratio (O/C ratio) of approximately 0.4 or higher by surface-treatment of the primary particle-type carbon black, the carbon black is aggregated to prepare the secondary particle-type carbon black, which is then mixed with other ingredients, and pulverized and dispersed, thereby effectively preparing the silver paste composition exhibiting excellent printability, electrical characteristics and energy conversion properties.

Each step of the preparation method of the silver paste composition of another embodiment is described as follows.

First, in the surface-treatment of carbon black, commercially available primary particle-type carbon black is subjected to heat, plasma, or acid surface-treatment so as to increase the number of oxygen atom exposed on the surface of carbon black. In this regard, the primary particle-type carbon black may have a diameter of approximately 20 to 50 nm or approximately 20 to 30 nm. After proper surface-treatment, it is aggregated into the secondary particle-type carbon black.

In the surface-treatment of carbon black, for example, the carbon black is put in an ultrasonic plasma treatment device, and plasma surface-treatment may be performed for approximately 100 to 130 min or approximately 110 to 120 min by applying an electric power of approximately 5 to 20 W, or the carbon black is put in a furnace, and heat surface-treatment may be performed at a temperature of approximately 600 to 1000°C or approximately 700 to 900°C for approximately 10 min to 1 hr or approximately 20 to 50 min.

In this regard, the primary particle-type carbon black may have a BET specific surface area of approximately 100 to 200 m²/g or approximately 100 to 150 m²/g, and this primary particle-type carbon black is used to perform the proper surface-treatment, thereby preparing carbon black satisfying the above described oxygen/carbon atomic ratio. In addition, it enables the carbon black to be more favorably dispersed in the final silver paste composition, and enables the silver paste composition to show more improved printability.

After the surface-treatment, the primary particle-type carbon black is aggregated to prepare the secondary particle-type carbon black have a diameter of approximately 1 to 5 µm or approximately 2 to 4 µm. This aggregation may be performed in a predetermined solvent according to the well-known method. After this aggregation, the secondary particle-type carbon black is mixed with other ingredients to prepare a paste mixture, and the silver paste composition is prepared by pulverization and dispersion. Finally, it is easier to adjust the proper viscosity of the silver paste composition, and the final silver paste composition can have more improved printability and processibility.

Subsequently, the secondary particle-type carbon black is mixed with other ingredients such as the silver powder, the glass frit powder, the organic binder, etc., so as to form the silver paste mixture. This silver paste mixture is dispersed to prepare the silver paste composition.

In this regard, individual ingredients may be mixed in a typical mixer, and they are added to the mixer and properly mixed.

Through the dispersion process, the diameter of the carbon black can be adjusted to approximately 0.02 to 2 µm, approximately 0.03 to 1 µm, or approximately 30 to 800 nm, and individual ingredients included in the carbon black are uniformly dispersed to prepare the silver paste composition of one embodiment. Through the dispersion process, rheological characteristics associated with viscosity and adhesion of the silver paste composition can be also improved. Therefore, the obtained silver paste composition of one embodiment is used to prepare the electrode having a thinner line width and a taller line height. Also, the silver paste composition shows more improved printability and processibility.

The dispersion process may be performed by repeating for three to six times using a 3 roll mill, a ball mill or a hammer mill, but is not limited thereto.

Meanwhile, according to still another embodiment, provided is a front electrode for a solar cell, which is formed from the above described silver paste composition, and a silicon solar cell including the same. The silicon solar cell includes a silicon semiconductor substrate; an emitter layer formed on the substrate; an antireflection film formed on the emitter layer; a front electrode connected to the emitter layer through the antireflection film; and a back electrode connected to a back surface of the substrate, in which the front electrode is formed by applying the above described silver paste composition of one embodiment on the antireflection film in a predetermined pattern and sintering the silver paste composition.

As such, as the front electrode is formed using the silver paste composition of one embodiment, the silicon solar cell includes the front electrode that includes the pattern having a thin line width of approximately 60 to 90 µm, or approximately 70 to 80 µm, or approximately 60 to 70 µm and a tall line height of 20 to 35 µm, or approximately 25 to 30 µm, or approximately 20 to 25 µm. Owing to the tall line height, resistance of the front electrode can be reduced, and electrical characteristics can be improved.

As described above, as the electrode is formed by using the silver paste composition that includes carbon black satisfying the predetermined physical properties (for example, surface oxygen/carbon atomic ratio or proper particle form or diameter range), the solar cell has more improved contact properties between silver of the front electrode and silicone of the emitter layer, and thus shows excellent energy conversion efficiency.

Meanwhile, the formation of the front electrode using the silver paste composition may include a process of printing the silver paste composition on a substrate in a predetermined pattern and sintering the silver paste composition.

In this regard, the substrate may include an antireflection film and an emitter layer. In addition, the substrate may be a substrate that is used in the manufacture of the typical semiconductor devices, and for example, a silicon substrate may be properly used.

The silver paste composition of one embodiment may be printed by applying a screen printing method, a doctor blade printing method, an offset printing method or an ink-jet printing method, and preferably the screen printing method.

Further, after the printing process, the silver paste composition may be sintered in a wide range of peak temperature of approximately 700 to 900°C or approximately 750 to 850°C for about 30 sec to 1 min for stable recrystallization of silver powder on the emitter layer. Through the sintering process, the carbon black and the organic binder can be removed, and the glass frit powder is melted onto the surface of silver powder, and therefore fire-through and ohmic-contact occur so as to form the front electrode showing excellent contact properties.

A schematic structure of the silicon solar cell including the front electrode is shown in FIG. 2. Referring to FIG. 2, the silicon solar cell may include a silicon substrate 201, an emitter layer (not shown) formed on the substrate 201, an antireflection film 202 formed on the emitter layer, a front electrode 203 connected to an upper surface of the emitter layer through the antireflection film 202, and a back electrode 205 connected to a back surface of the substrate 201. In addition, a p+ back surface field (BSF) layer 204 may be formed at an interface between the back electrode and the substrate, and the back electrode may include a predetermined silver electrode pattern 206.

The substrate 201 may be doped with a Group 3 element in the periodic table, for example, B, Ga, and In, as a p-type impurity. The emitter layer may be doped with a Group 5 element in the periodic table, for example, P, As, and Sb, as an n-type impurity. When the substrate 201 and emitter layer are doped with opposite conductivity type impurities as mentioned above, a p-n junction is formed at an interface between the substrate 201 and the emitter layer. Meanwhile, the p-n junction may be formed at an interface between the substrate 201 doped with an n-type impurity and the emitter layer doped with a p-type impurity.

The antireflection film 202 passivates a defect (for example, a dangling bond) that exists on the surface of or in the bulk of the emitter layer and reduces the incident light on a front surface of the substrate 201. If a defect of the emitter layer is passivated, a recombination site of a hydrophobic carrier is removed to increase an open-circuit voltage of the solar cell. As solar reflectivity decreases, an amount of light reaching the p-n junction increases and then a short-circuit current of the solar cell increases. Accordingly, a conversion efficiency of the solar cell increases as much as increases in the open-circuit voltage and the short-circuit current of the solar cell by the antireflection film 202.

The antireflection film 202 may have, for example, a monolayered or multilayered structure of two or more materials selected from the group consisting of a silicon nitride film, a silicon nitride film including hydrogen (SiNx), a silicon oxide film, a silicon oxide nitride film, MgF₂, ZnS, MgF₂, TiO₂ and CeO₂, but is not limited thereto. The antireflection film 202 may be formed by vacuum deposition, chemical vapor deposition, spin coating, screen printing or spray coating. However, the method of forming the antireflection film 202 according to the present invention is not limited thereto.

The front and back electrodes 203 and 205 are metal electrodes made from silver and aluminium, respectively. The front electrode 203 may be formed using the silver paste composition of one embodiment. The back electrode 205 may be formed using the typical aluminium paste composition and silver paste composition for the back electrode.

The front and back electrodes 203 and 205 may be formed by various well-known techniques, but is preferably formed by screen printing. Specifically, the front electrode 203 is formed by applying the above described silver paste composition of one embodiment on a front electrode forming area by screen printing, and performing a thermal treatment. Then, the front electrode is connected to the emitter layer 202 by a punch through (or fire-through) across the antireflection film 202.

Similarly, the back electrode 205 is formed by applying an aluminium paste composition for the back electrode including aluminium, quartz silica and an organic binder on the back surface of the substrate 201 by screen printing, and performing a thermal treatment. During the thermal treatment, aluminium constituting the electrode is dispersed through the back surface of the substrate 201, so that the back surface field layer 204 may be formed at an interface between the back electrode 205 and the substrate 201. The BSF layer prevents a carrier from moving to the back surface of the substrate 201 and recombining with the substrate 201, thereby increasing the open-circuit voltage and fidelity and improving the conversion efficiency of the solar cell. In addition, when the aluminium electrode is formed using the aluminum paste composition, a back Ag pad may be formed as a back silver electrode pattern 206 in a predetermined pattern by the typical deposition or screening printing method.

### [Mode for Invention]

Hereinafter, the actions and the effects of the present invention will be explained in more detail via specific examples of the invention. However, these examples are merely illustrative of the present invention and the scope of the invention should not be construed to be defined thereby.

### <Example 1>

First, primary particle-type carbon black (product name; MA100, BET specific surface area: approximately 100 m²/g) having a diameter of 20 to 30 nm was placed in an ultrasonic plasma treatment device, and surface heat treatment was performed at an electric power of 10 W for 120 min to form carbon black having a surface oxygen/carbon atomic ratio (O/C ratio) of 0.42. The oxygen/carbon atomic ratio was measured and examined by relative intensity of atomic oxygen and carbon peaks (oxygen atom: O₁ₛ peak; carbon atom: C₁ₛ peak) in XPS spectrum of carbon black, as described in Experimental Example 2.

Subsequently, the primary particle-type carbon black was aggregated to form secondary particle-type carbon black having a diameter of 1 to 5 µm.

80% by weight of a spherical silver powder having a mean diameter of 1 to 3 µm, 3% by weight of a glass frit powder (Bi₂O₃-B₂O₃-SiO₂ having a mean diameter of 10 µm), and 11.5% by weight of a binder solution prepared by dissolving 10 g of an organic binder (ethyl cellulose) in 61 g of butyl carbitol were mixed, and 5.5% by weight of the above secondary particle-type carbon black were mixed therewith to prepare a silver paste. Then, particles in the silver paste were dispersed by a three roll mill to prepare a silver paste composition including secondary particle-type carbon black having a diameter of approximately 100 nm to 1 µm. The final silver paste composition had a viscosity of 250,000 cP.

### <Example 2>

A silver paste composition was prepared in the same manner as in Example 1, except that PbO-ZnO-Al₂O₃-TiO₂ including PbO and having a mean diameter of 10 µm was used as the glass frit powder. The carbon black in the silver paste composition was found to be in a form of the secondary particles having a diameter of approximately 200 nm to 800 nm. The final silver paste composition had a viscosity of 260,000 cP.

### <Example 3>

A silver paste composition was prepared in the same manner as in Example 1, except that 2.7% by weight of PbO-ZnO-Al₂O₃-TiO₂ including PbO and having a mean diameter of 10 µm was used as the first glass frit powder, and 0.3% by weight of Bi₂O₃-TlOx-B₂O₃-SiO₂ having a mean diameter of 10 µm was used as the second glass frit powder. The carbon black in the silver paste composition was found to be in a form of the secondary particles having a diameter of approximately 400 nm to 1.2 m. The final silver paste composition had a viscosity of 230,000 cP.

### <Example 4>

A silver paste composition was prepared in the same manner as in Example 1, except that 80% by weight of spherical silver powder having a mean diameter of 2 to 3 µm was used as the silver powder. The carbon black in the silver paste composition was found to be in a form of the secondary particles having a diameter of approximately 300 nm to 900 nm. The final silver paste composition had a viscosity of 270,000 cP.

### <Example 5>

First, primary particle-type carbon black (product name; MA77; BET specific surface area: approximately 100 m²/g) having a diameter of 20 to 30 nm was put in a furnace, and heat treatment was performed at 800°C for 30 min to form carbon black having a surface oxygen/carbon atomic ratio (O/C ratio) of 0.41. Subsequently, a silver paste composition was prepared in the same manner as in Example 1. The carbon black in the silver paste composition was found to be in a form of the secondary particles having a diameter of approximately 300 nm to 1 m The final silver paste composition had a viscosity of 240,000 cP.

### <Comparative Example 1>

A silver paste composition was prepared in the same manner as in Example 1, except that carbon black was not subjected to ultrasonic plasma treatment. The surface oxygen/carbon atomic ratio (O/C ratio) of the carbon black was analyzed by XPS, as described in Experimental Example 2. The oxygen/carbon atomic ratio defmed as a relative intensity of atomic oxygen and carbon peaks (oxygen atom: O₁ₛ peak; carbon atom: C₁ₛ peak), namely, intensity of O₁ₛ peak/ intensity of C₁ₛ peak was <0.01.

### <Experimental Example 1>

A silicon solar cell having a structure of FIG. 2 was manufactured by the typical method, in which the silicon solar cell includes a silicon semiconductor substrate 201, an emitter layer formed on the substrate 201, an antireflection film 202 formed on the emitter layer, a front electrode 203 connected to an upper surface of the emitter layer through the antireflection film 202, and a back electrode 205 connected to a back surface of the substrate 201. In this regard, when the front electrode is formed, the silver paste compositions of Examples 1 to 5 and Comparative Example 1 were applied onto the substrate by screen printing, and sintered. The sintering process was performed at a temperature of 600 to 800°C for 30 sec.

Subsequently, physical properties (Jsc, Voc, fill factor (FF), energy conversion efficiency) of each solar cell were measured by the typical method, and the results are shown in Table 1. The line width and line height of the electrodes formed in Examples and Comparative Example were also shown in the following Table 1.

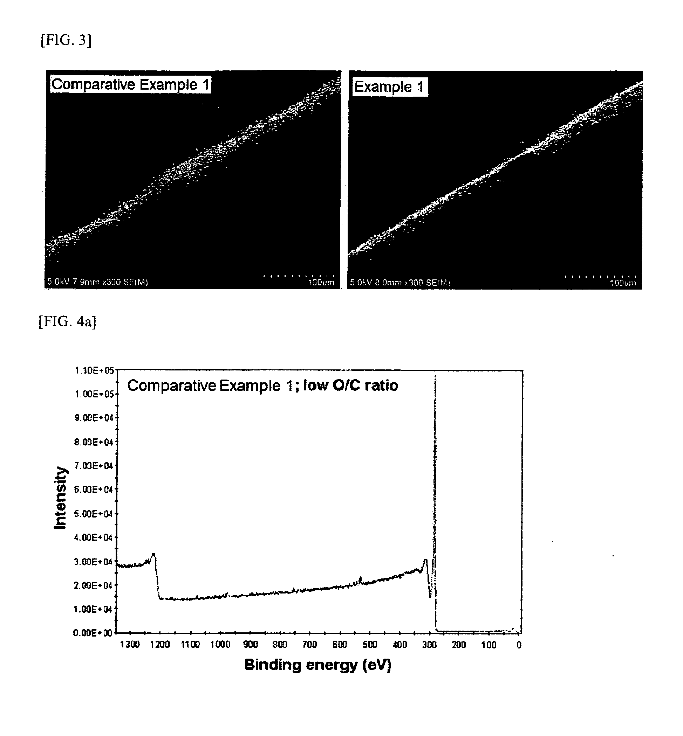

In addition, the electron microscopic images of the front electrodes for a solar cell manufactured using silver paste compositions of Example 1 and Comparative Example 1, taken at the optimal view angle for each stereoscopic image, were shown in FIG. 3.

**[Table 1]**

| | Jsc (mA/cm²) | Voc(mV) | FF | Conversion efficiency (%) | Line width (µm) | Line height (µm) |
|---|---|---|---|---|---|---|
| Example 1 | 35.12 | 0.6297 | 79.76 | 17.64 | 73 | 29 |
| Example 2 | 35.30 | 0.6300 | 79.70 | 17.72 | 72 | 28 |
| Example 3 | 35.21 | 0.6325 | 79.72 | 17.75 | 75 | 30 |
| Example 4 | 35.38 | 0.6329 | 79.81 | 17.87 | 78 | 27 |
| Example 5 | 35.13 | 0.6318 | 79.87 | 17.73 | 79 | 25 |
| Comparative Example 1 | 35.20 | 0.6280 | 79.00 | 17.46 | 83 | 25 |

Referring to Table 1, as the electrodes of Examples 1 to 5 were formed using the silver paste compositions including carbon black having the improved surface oxygen/carbon atomic ratio, the solar cells were found to show more excellent energy conversion efficiency (light conversion efficiency). In particular, considering that even a 0.1% increase in energy conversion efficiency is not easy, the improvement in energy conversion efficiency in Examples was very significant.

Referring to Table 1 and FIG. 3, when the silver paste compositions of Examples 1 to 5 were used, the broadness of the line width was inhibited, and electrodes having a line height taller than that of Comparative Example 1 were formed. More particularly, referring to FIG. 3, it was found that the electrode formed in Example 1 had a thinner line width and a taller line height than that formed in Comparative Example 1, and the silver paste compositions of Examples 1 to 5 showed better printability to greatly reduce the broadness of the line width of the electrode, compared to Comparative Example 1.

### <Experimental Example 2>

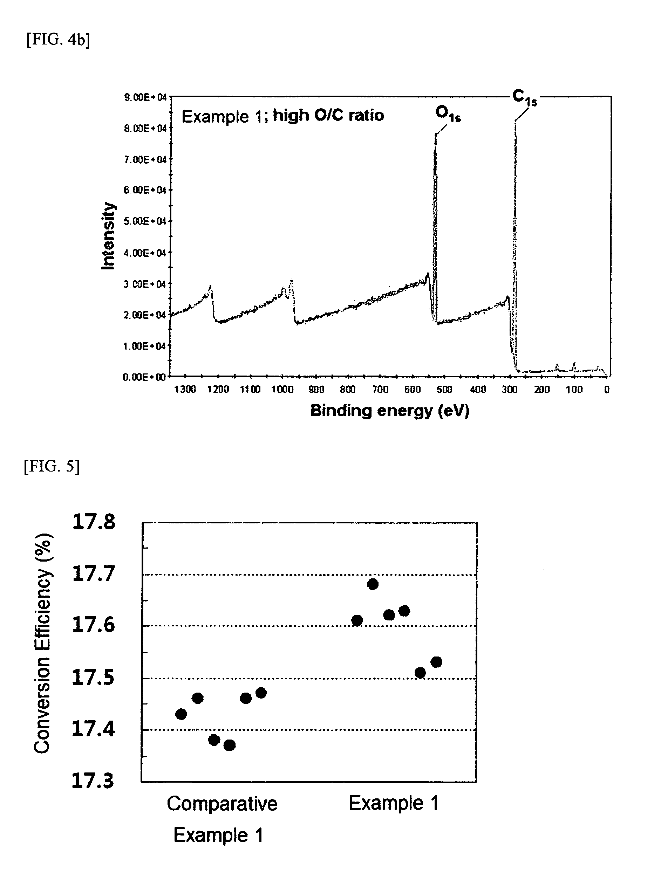

FIGs. 4a and 4b show graphs of carbon black used in Comparative Example 1 and Example 1, analyzed by XPS (Instrument name: ESCALab250). As shown in FIGs. 4a and 4b, it was found that the carbon black of Example 1 had the higher number of surface oxygen atoms than that of carbon atoms and thus had the oxygen/carbon atomic ratio of approximately 0.42, and the carbon black of Comparative Example 1 had the oxygen/carbon atomic ratio of approximately < 0.01.

### <Experimental Example 3>

FIG. 5 is a graph showing a comparison of energy conversion (light conversion) efficiency between each 6 of the solar cells of Example 1 and Comparative Example 1, which were manufactured under different heat treatment conditions. As shown in FIG. 5, the Example 1 showed the narrow line width and excellent ohmic contact, thereby improving FF values, and thus it showed more excellent energy conversion efficiency than the solar cell of Comparative Example 1.

## Claims

1. A silver paste composition for forming an electrode, comprising a silver powder, a glass frit powder, an organic binder, and carbon black, wherein the carbon black has a surface oxygen/carbon atomic ratio (O/C ratio) of 0.4 or higher.

2. The silver paste composition for forming an electrode according to claim 1, wherein the carbon black has a surface oxygen/carbon atomic ratio (O/C ratio) of 0.4 to 0.45.

3. The silver paste composition for forming an electrode according to claim 1, wherein the carbon black is in the form of secondary particles by attachment or aggregation of a plurality of primary particles.

4. The silver paste composition for forming an electrode according to claim 3, wherein the secondary particle-type carbon black has a diameter of 0.02 to 2 µm.

5. The silver paste composition for forming an electrode according to claim 1, wherein the carbon black is subjected to surface heat treatment, surface plasma treatment, or surface acid treatment so as to increase the number of oxygen atoms exposed on the surface of carbon black.

6. The silver paste composition for forming an electrode according to claim 1, wherein the carbon black is included in an amount of 1 to 10% by weight, based on the total weight of the silver paste composition.

7. The silver paste composition for forming an electrode according to claim 1, wherein the silver paste composition has a viscosity of 100,000 to 400,000 cP (brookfield viscometer, spindle 14, measurement temperature 25°C, rotation speed 10 rpm).

8. The silver paste composition for forming an electrode according to claim 1, wherein the silver powder includes a spherical silver powder having a mean diameter of 1 to 3 µm.

9. The silver paste composition for forming an electrode according to claim 1, wherein the silver powder is included in an amount of 70 to 90% by weight, based on the total weight of the silver paste composition.

10. The silver paste composition for forming an electrode according to claim 1, wherein the glass frit powder is a lead-containing glass frit powder containing PbO.

11. The silver paste composition for forming an electrode according to claim 1, wherein the glass frit powder is included in an amount of 1 to 5% by weight, based on the total weight of the silver paste composition.

12. The silver paste composition for forming an electrode according to claim 1, wherein the organic binder includes one or more selected from the group consisting of cellulose resins, acrylic resins, butyl carbitol, and terpineol.

13. The silver paste composition for forming an electrode according to claim 1, wherein the organic binder is included in an amount of 5 to 15% by weight, based on the total weight of the silver paste composition.

14. A method for preparing a silver paste composition for forming an electrode, comprising the steps of
preparing a silver paste that includes a silver powder, a glass frit powder, an organic binder, and secondary particle-type carbon black having a surface oxygen/carbon atomic ratio (O/C ratio) of 0.4 or higher and a diameter of 1 to 5 µm; and
dispersing the silver paste.

15. The method for preparing a silver paste composition for forming an electrode according to claim 14, further comprising the steps of:
forming carbon black having the surface oxygen/carbon atomic ratio (O/C ratio) of 0.4 or higher by surface-treatment of the primary particle-type carbon black having a diameter of 20 to 50 nm; and
aggregating the surface-treated carbon black to prepare the secondary particle-type carbon black having a diameter of 1 to 5 µm,
before preparation of the paste.

16. The method for preparing a silver paste composition for forming an electrode according to claim 14, wherein the silver paste after the dispersion step includes the secondary particle-type carbon black having a diameter of 0.02 to 2 µm.

17. The method for preparing a silver paste composition for forming an electrode according to claim 15, wherein the primary particle-type carbon black has a BET specific surface area of 100 to 200 m²/g.

18. The method for preparing a silver paste composition for forming an electrode according to claim 14, wherein the dispersion step is performed by repeating for three to six times using a 3 roll mill, a ball mill or a hammer mill.

19. A front electrode for a solar cell, which is formed from the silver paste composition according to any one of claims 1 to 13.

20. A silicon solar cell, comprising
a silicon semiconductor substrate;
an emitter layer formed on the substrate;
an antireflection film formed on the emitter layer;
a front electrode connected to the emitter layer through the antireflection film; and
a back electrode connected to a back surface of the substrate,
wherein the front electrode is formed by applying the silver paste composition according to any one of claims 1 to 13 on the antireflection film in a predetermined pattern and sintering the silver paste composition.

21. The silicon solar cell according to claim 20, wherein the front electrode has a line width of 60 to 90 µm and a line height of 20 to 35 µm.

## Patentansprüche

1. Silberpastenzusammensetzung zum Bilden einer Elektrode, umfassend ein Silberpulver, ein Glasfrittenpulver, ein organisches Bindemittel und Ruß, wobei der Ruß ein atomares Oberflächenverhältnis von Sauerstoff/Kohlenstoff (O/C-Verhältnis) von 0,4 oder höher aufweist.

2. Silberpastenzusammensetzung zum Bilden einer Elektrode nach Anspruch 1, wobei der Ruß ein atomares Oberflächenverhältnis von Sauerstoff/Kohlenstoff (O/C-Verhältnis) von 0,4 bis 0,45 aufweist.

3. Silberpastenzusammensetzung zum Bilden einer Elektrode nach Anspruch 1, wobei der Ruß in der Form von Sekundärteilchen durch Anfügung oder Aggregation einer Vielzahl von Primärteilchen ist.

4. Silberpastenzusammensetzung zum Bilden einer Elektrode nach Anspruch 3, wobei der Ruß des Sekundärteilchentyps einen Durchmesser von 0,02 bis 2 µm aufweist.

5. Silberpastenzusammensetzung zum Bilden einer Elektrode nach Anspruch 1, wobei der Ruß einer Oberflächenwärmebehandlung, Oberflächenplasmabehandlung oder Oberflächensäurebehandlung unterzogen ist, um die Anzahl an Sauerstoffatomen zu erhöhen, die auf der Oberfläche des Rußes exponiert sind.

6. Silberpastenzusammensetzung zum Bilden einer Elektrode nach Anspruch 1, wobei der Ruß in einer Menge von 1 bis 10 Gewichtsprozent, basierend auf dem Gesamtgewicht der Silberpastenzusammensetzung, eingeschlossen ist.

7. Silberpastenzusammensetzung zum Bilden einer Elektrode nach Anspruch 1, wobei die Silberpastenzusammensetzung eine Viskosität von 100.000 bis 400.000 cP (Brookfield-Viscometer, Spindle 14, Messtemperatur 25°C, Drehgeschwindigkeit 10 UpM) aufweist.

8. Silberpastenzusammensetzung zum Bilden einer Elektrode nach Anspruch 1, wobei das Silberpulver ein kugelförmiges Silberpulver mit einem mittleren Durchmesser von 1 bis 3 µm einschließt.

9. Silberpastenzusammensetzung zum Bilden einer Elektrode nach Anspruch 1, wobei das Silberpulver in einer Menge von 70 bis 90 Gewichtsprozent, basierend auf dem Gesamtgewicht der Silberpastenzusammensetzung, eingeschlossen ist.

10. Silberpastenzusammensetzung zum Bilden einer Elektrode nach Anspruch 1, wobei das Glasfrittenpulver ein bleienthaltendes Glasfrittenpulver enthaltend PbO ist.

11. Silberpastenzusammensetzung zum Bilden einer Elektrode nach Anspruch 1, wobei das Glasfrittenpulver in einer Menge von 1 bis 5 Gewichtsprozent, basierend auf dem Gesamtgewicht der Silberpastenzusammensetzung, eingeschlossen ist.

12. Silberpastenzusammensetzung zum Bilden einer Elektrode nach Anspruch 1, wobei das organische Bindemittel eines oder mehrere einschließt, die ausgewählt sind aus der Gruppe bestehend aus Celluloseharzen, Acrylharzen, Butylcarbitol und Terpineol.

13. Silberpastenzusammensetzung zum Bilden einer Elektrode nach Anspruch 1, wobei das organische Bindemittel in einer Menge von 5 bis 15 Gewichtsprozent, basierend auf dem Gesamtgewicht der Silberpastenzusammensetzung, eingeschlossen ist.

14. Verfahren zum Herstellen einer Silberpastenzusammensetzung zum Bilden einer Elektrode, umfassend die Schritte:
Herstellen einer Silberpaste, die ein Silberpulver, ein Glasfrittenpulver, ein organisches Bindemittel und Ruß des Sekundärteilchentyps mit einem atomaren Oberflächenverhältnis Sauerstoff/Kohlenstoff (O/C-Verhältnis) von 0,4 oder höher und einem Durchmesser von 1 bis 4 µm einschließt; und
Dispergieren der Silberpaste.

15. Verfahren zum Herstellen einer Silberpastenzusammensetzung zum Bilden einer Elektrode nach Anspruch 14, weiter umfassend die Schritte:
Bilden von Ruß mit dem atomaren Oberflächenverhältnis Sauerstoff/Kohlenstoff (O/C-Verhältnis) von 0,4 oder höher durch Oberflächenbehandlung des Rußes des Primärteilchentyps mit einem Durchmesser von 20 bis 50 nm; und
Aggregieren des oberflächenbehandelten Rußes, um den Ruß des Sekundärteilchentyps mit einem Durchmesser von 1 bis 5 µm herzustellen,
vor Herstellung der Paste.

16. Verfahren zum Herstellen einer Silberpastenzusammensetzung zum Bilden einer Elektrode nach Anspruch 14, wobei die Silberpaste nach dem Dispersionsschritt den Ruß des Sekundärteilchentyps mit einem Durchmesser von 0,02 bis 2 µm einschließt.

17. Verfahren zum Herstellen einer Silberpastenzusammensetzung zum Bilden einer Elektrode nach Anspruch 15, wobei der Ruß des Primärteilchentyps eine spezifische Oberfläche nach BET von 100 bis 200 m²/g aufweist.

18. Verfahren zum Herstellen einer Silberpastenzusammensetzung zum Bilden einer Elektrode nach Anspruch 14, wobei der Dispersionsschritt durch Wiederholen für drei- bis sechsmal unter Verwendung einer Dreiwalzenmühle, einer Kugelmühle oder einer Hammermühle durchgeführt wird.

19. Frontelektrode für eine Solarzelle, die aus der Silberpastenzusammensetzung nach einem der Ansprüche 1 bis 13 gebildet ist.

20. Siliziumsolarzelle, welche umfasst:
ein Siliziumhalbleitersubstrat;
eine auf dem Substrat gebildete Emitterschicht;
ein auf der Emitterschicht gebildeter Antireflexionsfilm;
eine Frontelektrode, die mit der Emitterschicht durch den Antireflexionsfilm verbunden ist; und
eine Rückelektrode, die mit einer Rückfläche des Substrats verbunden ist,
wobei die Frontelektrode durch Beaufschlagen der Silberpastenzusammensetzung nach einem der Ansprüche 1 bis 13 auf den Antireflexionsfilm in einem vorgegebenen Muster und Sintern der Silberpastenzusammensetzung gebildet ist.

21. Siliziumsolarzelle nach Anspruch 20, wobei die Frontelektrode eine Linienbreite von 60 bis 90 µm und eine Linienhöhe von 20 bis 35 µm aufweist.

## Revendications

1. Une composition de pâte d'argent pour former une électrode, comprenant une poudre d'argent, une poudre de fritte de verre, un liant organique et du noir de carbone, dans laquelle le noir de carbone a un rapport atomique oxygène/carbone (rapport O/C) en surface égal ou supérieur à 0,4.

2. La composition de pâte d'argent pour former une électrode selon la revendication 1, dans laquelle le noir de carbone a un rapport atomique oxygène/carbone (rapport O/C) en surface compris entre 0,4 et 0,45.

3. La composition de pâte d'argent pour former une électrode selon la revendication 1, dans laquelle le noir de carbone est sous forme de particules secondaires par la fixation ou l'agrégation d'une pluralité de particules primaires.

4. La composition de pâte d'argent pour former une électrode selon la revendication 3, dans laquelle le noir de carbone de type à particules secondaires a un diamètre compris entre 0,02 et 2 µm.

5. La composition de pâte d'argent pour former une électrode selon la revendication 1, dans laquelle le noir de carbone est soumis à un traitement thermique de surface, un traitement de surface par plasma ou un traitement de surface à l'acide de façon à augmenter le nombre d'atomes d'oxygène exposés à la surface du noir de carbone.

6. La composition de pâte d'argent pour former une électrode selon la revendication 1, dans laquelle le noir de carbone est inclus dans une quantité comprise entre 1 et 10% en poids, sur la base du poids total de la composition de pâte d'argent.

7. La composition de pâte d'argent pour former une électrode selon la revendication 1, dans laquelle la composition de pâte d'argent a une viscosité comprise entre 100 000 et 400 000 cP (viscosimètre brookfield, broche 14, température de mesure 25°C, vitesse de rotation 10 tr/mn).

8. La composition de pâte d'argent pour former une électrode selon la revendication 1, dans laquelle la poudre d'argent inclut une poudre d'argent sphérique ayant un diamètre moyen compris entre 1 est 3 µm.

9. La composition de pâte d'argent pour former une électrode selon la revendication 1, dans laquelle la poudre d'argent est incluse dans une quantité comprise entre 70 to 90% en poids, sur la base du poids total de la composition de pâte d'argent.

10. La composition de pâte d'argent pour former une électrode selon la revendication 1, dans laquelle la poudre de fritte de verre est une poudre de fritte de verre contenant du plomb contenant PbO.

11. La composition de pâte d'argent pour former une électrode selon la revendication 1, dans laquelle la poudre de fritte de verre est incluse dans une quantité comprise entre 1 et 5% en poids, sur la base du poids total de la composition de pâte d'argent.

12. La composition de pâte d'argent pour former une électrode selon la revendication 1, dans laquelle le liant organique inclut un ou plusieurs éléments sélectionnés dans le groupe constitué par les résines cellulosiques, les résines acryliques, le butyl carbitol et le terpinéol.

13. La composition de pâte d'argent pour former une électrode selon la revendication 1, dans laquelle le liant organique est inclus dans une quantité comprise entre 5 et 15% en poids, sur la base du poids total de la composition de pâte d'argent.

14. Un procédé de préparation d'une composition de pâte d'argent pour former une électrode, comprenant les étapes de :
la préparation d'une pâte d'argent qui inclut une poudre d'argent, une poudre de fritte de verre, an liant organique et du noir de carbone de type à particules secondaires ayant un rapport atomique oxygène/carbone (rapport O/C) en surface égal ou supérieur à 0,4 et un diamètre compris entre 1 et 5 µm ; et
la dispersion de la pâte d'argent.

15. Le procédé de préparation d'une composition de pâte d'argent pour former une électrode selon la revendication 14, comprenant en outre les étapes de :
la formation de noir de carbone ayant un rapport atomique oxygène/carbone (rapport O/C) en surface égal ou supérieur à 0,4 par un traitement de surface du noir de carbone de type à particules primaires ayant un diamètre compris entre 20 et 50 nm ; et
l'agrégation du noir de carbone traité en surface pour préparer le noir de carbone de type à particules secondaires ayant un diamètre compris entre 1 et 5 µm,
avant la préparation de la pâte.

16. Le procédé de préparation d'une composition de pâte d'argent pour former une électrode selon la revendication 14, dans lequel la pâte d'argent après l'étape de dispersion inclut le noir de carbone de type à particules secondaires ayant un diamètre compris entre 0,02 et 2 µm.

17. Le procédé de préparation d'une composition de pâte d'argent pour former une électrode selon la revendication 15, dans lequel le noir de carbone de type à particules primaires a une surface spécifique BET comprise entre 100 et 200 m²/g.

18. Le procédé de préparation d'une composition de pâte d'argent pour former une électrode selon la revendication 14, dans lequel l'étape de la dispersion est exécutée en la répétant entre trois et six fois à l'aide d'un laminoir à 3 cylindres, d'un broyeur à billes ou d'un broyeur à marteaux.

19. Une électrode avant pour une cellule solaire, laquelle est formée à partir de la composition de pâte d'argent selon l'une quelconque des revendications 1 à 13.

20. Une cellule solaire en silicium, comprenant
un substrat semi-conducteur en silicium ;
une couche émettrice formée sur le substrat ;
un film antireflet formé sur la couche émettrice ;
une électrode avant connectée à la couche émettrice par le film antireflet ; et
une électrode arrière connectée à une surface arrière du substrat,
dans laquelle l'électrode avant est formée par l'application de la composition de pâte d'argent selon l'une quelconque des revendications 1 à 13 sur le film antireflet en un motif prédéterminé et le frittage de la composition de pâte d'argent.

21. La cellule solaire en silicium selon la revendication 20, dans laquelle l'électrode avant a une largeur de ligne comprise entre 60 et 90 µm et une hauteur de ligne comprise entre 20 et 35 µm.
